# EUROPEAN PATENT APPLICATION

(11) **EP 2 031 758 A1**
(43) Date of publication of application: **04.03.2009**
(21) Application number: 08162317.5
(22) Date of filing: 13.08.2008
(51) Int. Cl.: H03K 17/082

(54) **Protecting circuit**

(30) Priority: 29.08.2007 JP 2007222160
(71) Applicant: YAZAKI CORPORATION, Minato-ku, Tokyo (JP)
(72) Inventor: Morimoto, Mitsuaki, Shizuoka Shizuoka (JP)
(74) Representative: Smee, Anthony James Michael

(57) **Abstract**

A protecting circuit includes a semiconductor switch (Q) that is provided between a power source (10) and a load (20), a current detecting unit (31) that detects an electric current flowing in the semiconductor switch (Q), a protecting unit (33) that controls the semiconductor switch (Q) to be turned off when the current detected by the current detecting unit (31) exceeds a threshold value, a temperature detecting unit (32) that detects an ambient temperature, and a threshold value changing unit that changes the threshold value so as to lower the threshold value as the temperature detected by the temperature detecting unit becomes higher.

## Description

### BACKGROUND

The present invention relates to a protecting circuit, and more particularly to a protecting circuit including a semiconductor switch provided between a power source and a load, a current detecting unit that detects an electric current supplied to the semiconductor switch and a protecting unit that controls the semiconductor switch to be turned off when the current detected by the current detecting unit exceeds a threshold value.

As a power supply circuit for supplying a power from a battery to a load such as an electrical device mounted on a motor vehicle, there is a circuit in which a semiconductor switch such as a transistor is provided between the load and the battery and the semiconductor switch is turned on and off to control the driving of the load. The capacity of a current of the semiconductor switch is determined by a maximum current such as a lock current supplied to the load. In the above-described power supply device for driving the load by using the semiconductor switch, a protecting circuit is necessary for protecting the semiconductor switch not to be broken by the abnormality or the short-circuit of the load.

Usually, as one example of the above-described protecting circuit, for instance, a protecting circuit as disclosed in Patent Document 1 is proposed. This protecting circuit protects a semiconductor switch by deciding an abnormality to turn off the semiconductor switch when a current supplied to a load exceeds a prescribed threshold value.

However, in the above-described usual protecting circuit, even when the ambient temperature of the semiconductor switch changes, since the threshold value does not change, a device needs to be selected that has no problem in generated heat even when a maximum current is supplied under a state that a working temperature is the highest as the semiconductor switch for driving the load. Accordingly, a problem arises that when the working temperature is low, the semiconductor switch is turned off under a state that a reserve power is considerably left.
[Patent Document 1] JP-A-2001-004674

### SUMMARY

Thus, the present invention is devised by considering the above-described problems and it is an object of the present invention to provide a protecting circuit that can reduce the size and cost of a semiconductor switch by completely using the performance of the semiconductor switch.

In order to achieve the above object, according to the present invention, there is provided a protecting circuit, comprising:
a semiconductor switch that is provided between a power source and a load;
a current detecting unit that detects an electric current flowing in the semiconductor switch;
a protecting unit that controls the semiconductor switch to be turned off when the current detected by the current detecting unit exceeds a threshold value;
a temperature detecting unit that detects an ambient temperature; and
a threshold value changing unit that changes the threshold value so as to lower the threshold value as the temperature detected by the temperature detecting unit becomes higher.

Preferably, the temperature detecting unit includes a diode for protecting a reverse connection of the power source, and the diode being provided between the power source and the load.

Preferably, the temperature detecting unit detects the temperature on the basis of an end-to-end voltage of the diode for protecting the reverse connection and the current detected by the current detecting unit.

Preferably, the protecting circuit further comprises a driving unit that supplies a pulse signal to the semiconductor switch to pulse drive the semiconductor switch. As at least one of a frequency of the pulse signal is higher and a duty ratio is larger, the threshold value changing unit changes the threshold value so as to be lower.

As described above, according to the above configuration, since the threshold value changing unit changes the threshold value so as to lower the threshold value as the temperature detected by the temperature detecting unit becomes higher, the performance of the semiconductor switch can be fully used and the size and cost of the semiconductor switch can be reduced.

According to the above configuration, since the temperature detecting unit includes the diode for protecting the reverse connection of the power source, the diode for protecting the reverse connection and the temperature detecting unit do not need to be separately provided. Thus, the cost can be lowered.

According to the above configuration, since the temperature detecting unit detects the temperature on the basis of the end-to-end voltage of the diode for protecting the reverse connection and the current detected by the current detecting unit, the current detecting unit for detecting the temperature and a current detecting unit for interrupting a current do not need to be separately provided. Thus, the cost can be lowered.

According to the above configuration, since as the frequency of the pulse signal is higher or/and the duty ratio is larger, the threshold value changing unit changes the threshold value so as to be lower, the semiconductor switch can be interrupted by further considering the heat generation of the semiconductor switch due to a switching loss. Thus, the breakage of the semiconductor switch due to a thermal stress can be prevented.

### BRIEF DESCRIPTION OF THE DRAWINGS

The above objects and advantages of the present invention will become more apparent by describing in detail preferred exemplary embodiments thereof with reference to the accompanying drawings, wherein:
Fig. 1 is a circuit diagram showing a power supply device in which a protecting circuit of the present invention in a first embodiment is incorporated;
Fig. 2 is a block diagram showing a functional block of a CPU shown in Fig.1;
Figs. 3A and 3B are graphs showing a relation between a threshold value and an ambient temperature;
Fig. 4 is a flowchart showing a procedure of the CPU shown in Fig. 1;
Fig. 5 is a circuit diagram showing a power supply device in which a protecting circuit of the present invention in a second embodiment is incorporated;
Fig. 6 is a block diagram showing a functional block of a CPU shown in Fig.5;
Fig. 7 is a graph showing voltage-current characteristics depending on the temperature of a diode for protecting a reverse connection; and
Fig. 8 is a block diagram showing a functional block of a CPU in a third embodiment.

### DETAILED DESCRIPTION OF EXEMPLARY EMBODIMENTS

### First Embodiment

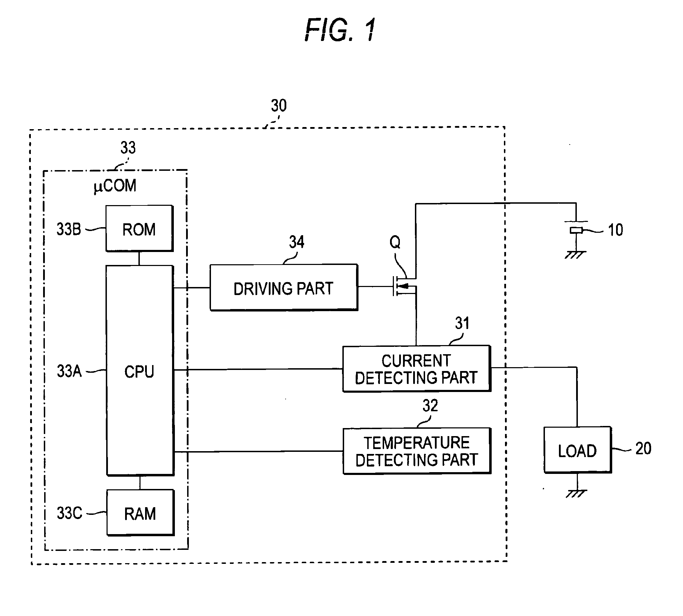

Now, an embodiment of the present invention will be described by referring to the drawings. Fig. 1 is a circuit diagram showing a power supply device in which a protecting circuit 30 of the present invention in a first embodiment is incorporated. As shown in Fig. 1, the power supply device includes a battery 10 as a power source, a load 20 and the protecting circuit 30. The battery 10 is a dc power source mounted on a vehicle. The load 20 is an electrical device such as a wiper motor, a lamp or the like operating by receiving the supply of a power from the battery 10.

The protecting circuit 30 includes a field effect transistor (FET)Q as a semiconductor switch, a current detecting part 31 as a current detecting unit, a temperature detecting part 32 as a temperature detecting unit, a microcomputer (µ COM) 33 and a driving part 34. The FETQ is provided between the battery 10 and the load 20. The FETQ has a drain connected to the battery 10, a source connected to the load 20 and a gate connected to the below-described driving part 34.

The current detecting part 31 detects a current supplied between the drain and the source of the FETQ and outputs the detected result to the below-described µ COM 33. As the current detecting part 31, any of units that can detect the current supplied to the FETQ may be employed and a unit using a detecting resistance may be employed or a unit using a Hall element may be employed. The temperature detecting part 32 detects an ambient temperature and outputs the detected result to the below-described µ COM 33. As the temperature detecting part 32, any of units that can detect the ambient temperature may be employed, and, for instance, a unit using a temperature detecting element such as a temperature measuring resistance may be employed.

The µ COM 33 includes a central processing unit (CPU) 33A for controlling the entire part of the protecting circuit 30 and carrying out various kinds of processes in accordance with a processing program, a ROM 33B as a read-only memory in which programs of the processes executed by the CPU 33A are stored and a RAM 33C as a readable and writeable memory having a work area used in the courses of the various kinds of processes in the CPU 33A and a data storing area for storing data.

When the driving part 34 receives an on signal from the µ COM 33, the driving part 34 supplies a driving voltage to the gate of the FETQ to turn on the FETQ. Further, when the driving part 34 receives an off signal from the µ COM 33, the driving part 34 interrupts the driving voltage to the gate of the FETQ to turn off the FETQ.

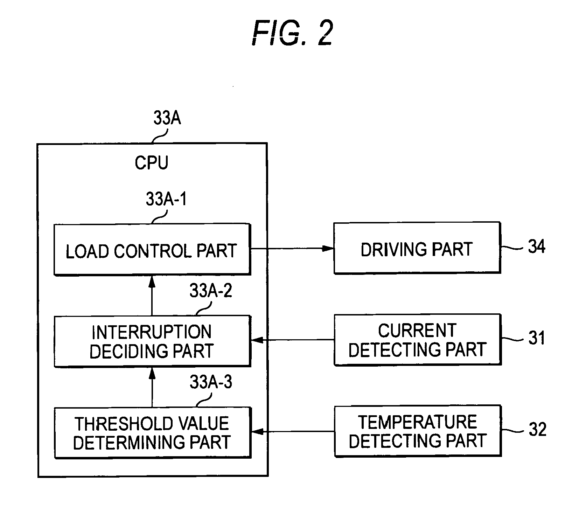

Now, a functional block of the above-described CPU 33A will be described by referring to Fig. 2. As shown in Fig. 2, the CPU 33A includes a load control part 33A-1, an interruption deciding part 33A-2 and a threshold value determining part 33A-3. The load control part 33A-1 detects an on/off state of a switch for controlling the load 20 such as a wiper switch or a lamp switch. When the above-described switch is turned on, the load control part 33A-1 outputs an on signal to the driving part 34 to drive the load 20. When the above-described switch is turned off, the load control part 33A-1 outputs an off signal to the driving part 34 to stop the supply of a power to the load 20. Further, when the below-described interruption deciding part 33A-2 decides an interruption, the load control part 33A-1 outputs an off signal to the driving part 34 even when the switch is turned on.

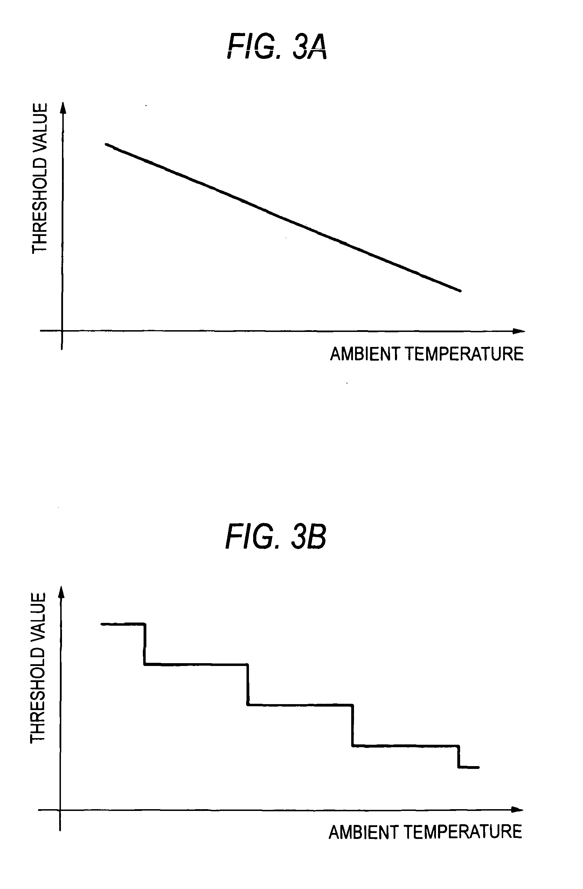

The interruption deciding part 33A-2 as a protecting unit decides the interruption when the current detected by the current detecting part 31 exceeds a threshold value determined by the below-described threshold value determining part 33A-3. The threshold value determining part 33A-3 as a threshold value changing unit changes and determines the threshold value so as to be lower as the temperature detected by the temperature detecting part 32 becomes higher as shown in Figs. 3A and 3B. The threshold value determining part 33A-3 may change the threshold value so as to be continuously lower as the ambient temperature becomes higher as shown in Fig. 3A or may change the threshold value so as to be intermittently lower as the ambient temperature is becomes higher as shown in Fig. 3B.

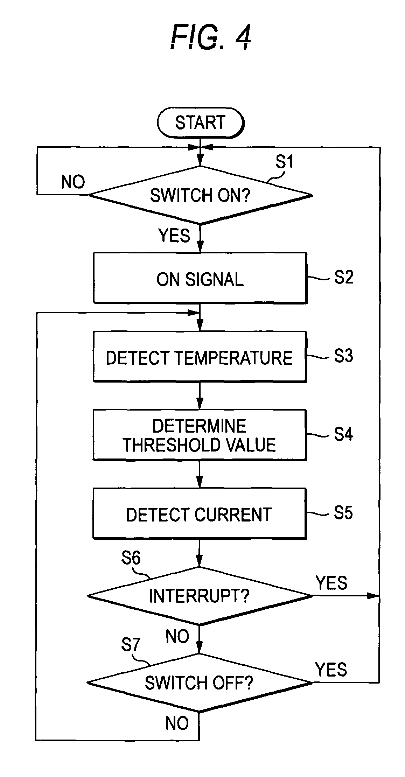

Now, an operation of the power supply device having the above-described structure will be described below by referring to a flowchart shown in Fig. 4. The CPU 33A starts a process in accordance with an ignition-on of a vehicle. Initially, the CPU 33A decides whether or not the switch for controlling the load 20 is turned on (step S1). When the switch is turned on (Y in the step S1), the CPU 33A outputs the on signal to the driving part 34 (step S2). In accordance with the output of the on signal, the driving voltage is supplied to the base of the FETQ from the driving part 34 to turn on the FETQ and supply the power of the battery 10 to the load 20.

Then, the CPU 33A fetches the temperature detected by the temperature detecting part 32 (step S3) to determine the threshold value meeting the ambient temperature as shown in Figs. 3A and 3B (step S4). Then, the CPU 33A fetches the current detected by the current detecting part 31 (step S5) to decide whether or not the fetched current exceeds the threshold value determined in the step S4 (step S6). When the current exceeds the threshold value, the CPU 33A decides to interrupt the driving voltage (Y in the step S6), outputs the off signal to the driving part 34 (step S7) and then returns to the step S1. In accordance with the output of the off signal, the driving voltage to the base of the FETQ from the driving part 34 is interrupted to turn off the FETQ and stop the supply of the power of the battery 10 to the load 20.

On the other hand, the CPU 33A decides that the current does not exceed the threshold value so that the interruption of the driving voltage is not necessary (N in the step S6), and then, decides whether or not the switch is turned off (step S7). When the switch is turned off (Y in the step S7), the CPU 33A advances to the step S8. When the switch is turned on (N in the step S7), the CPU 33A returns to the step S3.

In the above-described power supply device, as the temperature detected by the temperature detecting part 32 becomes higher, the CPU 33A changes the threshold value so as to lower the threshold value. That is, the threshold value is changed and determined so as to be high when the ambient temperature is low, and to be low when the ambient temperature is high. For instance, in the case of the wiper motor, it is assumed that a maximum current such as a lock current is supplied under a state that a wiper and glass are frozen or a state that a load is applied to a wiper due to snow. In both the cases, the ambient temperature is estimated to be low.

In such cases, since the environment of the FETQ is not thermally severe, even when a large quantity of current is supplied to the FETQ, the FETQ is not broken. In such a way, when the threshold value is changed so as to meet the ambient temperature, the performance of the FETQ can be fully employed. Accordingly, when the threshold value is fixed as in the usual device, a device needs to be selected as the FETQ that has no problem in generated heat even when the maximum current is supplied under a state that a working temperature is the highest. However, according to the above-described power supply device, for instance, even when a device is selected that has no problem in the generated heat by supplying the maximum current at an ordinary temperature, the device can be interrupted by a current lower than that at the ordinary temperature under a state that the working temperature is the highest. Thus, the thermal destruction of the FETQ can be prevented. Accordingly, the size and cost of the FETQ can be reduced.

### Second Embodiment

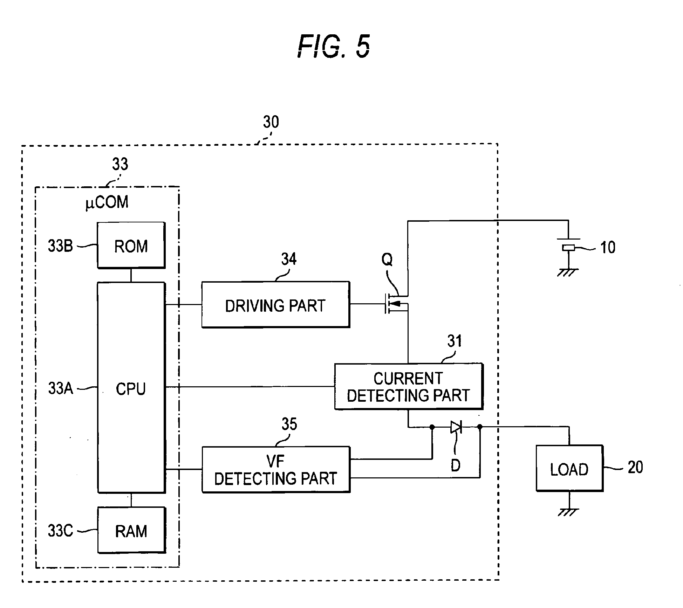

Now, a protecting circuit 30 of the present invention in a second embodiment will be described below. Fig. 5 is a circuit diagram showing a power supply device in which the protecting circuit 30 of the present invention in the second embodiment is incorporated. In Fig. 5, same parts as those in the circuit diagram of Fig. 1 that has already described in the first embodiment are designated by the same reference numerals and a detailed explanation of them will be omitted. As shown in Fig. 5, the power supply device includes a battery 10, a load 20 and the protecting circuit 30. Since the battery 10 and the load 20 are the same as those of the above-described first embodiment, a detailed explanation thereof will be omitted herein.

The protecting circuit 30 includes an FETQ, a current detecting part 31, a µ COM 33, a driving part 34, a diode D for protecting a reverse connection as a temperature detecting unit and a VF detecting part 35. Since the above-described FETQ, the current detecting part 31, the µ COM 33 and the driving part 34 are the same as those of the first embodiment, a detailed explanation of them will be omitted herein.

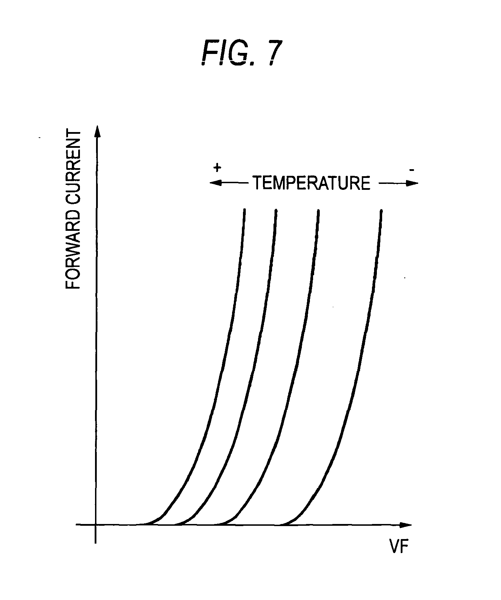

The diode D for protecting the reverse connection is a diode provided between the battery 10 and the load 20 so that a forward direction is directed toward the load 20 from the battery 10. This diode D for protecting the reverse connection prevents an over-current from being supplied to the battery 10 or the load 20 when the plus and the minus of the battery 10 are reversely connected by mistake. In the diode D for protecting the reverse connection, forward voltage-forward current characteristics change depending on a temperature as shown in Fig. 7. Accordingly, when the forward voltage VF and the forward current are known, an ambient temperature can be obtained.

The VF detecting part 35 detects the forward voltage VF of the diode D for protecting the reverse connection and supplies the detected result to the µ COM 33. The VF detecting part 35 is formed with a differential amplifier whose input is connected to both ends of the diode D for protecting the reverse connection.

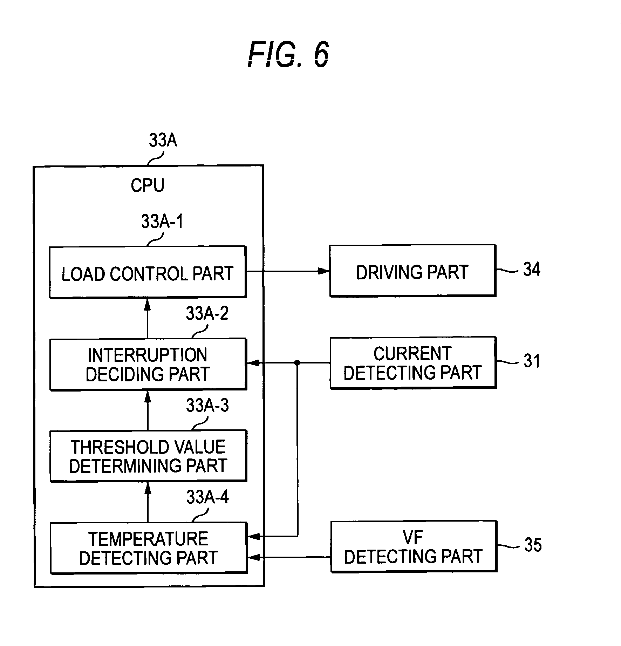

Now, a functional block of a CPU 33A forming the above-described µ COM 33 will be described by referring to Fig. 6. As shown in Fig. 6, the CPU 33A includes a load control part 33A-1, an interruption deciding part 33A-2, a threshold value determining part 33A-3 and a temperature detecting part 33A-4. Since above-described load control part 33A-1, the interruption deciding part 33A-2 and the threshold value determining part 33A-3 are the same as those of the above-described first embodiment, a detailed explanation of them will be omitted herein.

In the temperature detecting part 33A-4, the forward voltage-forward current characteristics as shown in Fig. 7 are stored. The temperature detecting part 33A-4 refers to a graph shown in Fig. 7 to detect the ambient temperature on the basis of the forward voltage VF detected by the VF detecting part 35 and the forward current of the diode D for protecting the reverse connection detected by the current detecting part 31. The threshold determining part 33A-3 determines a threshold value in accordance with the ambient temperature detected by the temperature detecting part 33A-4.

According to the above-described power supply device, since the ambient temperature is detected on the basis of the forward current and the forward voltage VF of the diode D for protecting the reverse connection, the diode D for protecting the reverse connection and an element for detecting the temperature do not need to be separately provided. Thus, a cost can be lowered.

### Third Embodiment

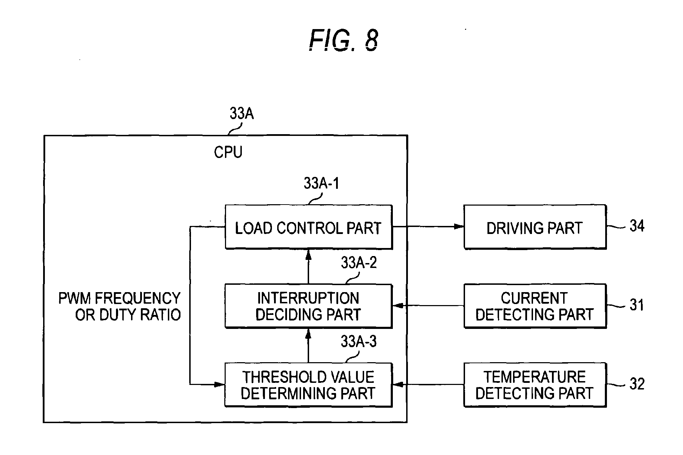

Now, a protecting circuit 30 of the present invention in a third embodiment will be described below. A large difference between a power supply device in the third embodiment and the power supply device in the first embodiment resides in a functional block of a CPU 33A. Fig. 8 is a block diagram showing the functional block of the CPU 33A in the third embodiment. As shown in Fig. 8, the CPU 33A includes a load control part 33A-1, an interruption deciding part 33A-2 and a threshold value determining part 33A-3. A load 20 in the third embodiment is driven under a PWM control by, for instance, a wiper motor.

In this embodiment, the load control part 33A-1 serves as a driving unit. For instance, when a wiper switch is turned on to select a high-speed rotation, the load control part 33A-1 supplies a pulse signal of a large duty ratio to a driving part 34. In accordance therewith, the driving part 34 supplies a pulse type driving voltage having the large duty ratio to the base of an FETQ to rotate the load 20 at high speed. Further, when the wiper switch is turned on to select a low-speed rotation, the load control part 33A-1 supplies a pulse signal of a small duty ratio to the driving part 34. In accordance therewith, the driving part 34 supplies the pulse type driving voltage of the small duty ratio to the base of the FETQ to rotate the load 20 at low speed.

Since the interruption deciding part 33A-2 is the same as that of the first embodiment, a detailed explanation thereof is omitted. The threshold value determining part 33A-3 changes and determines a threshold value depending on an ambient temperature as in the first embodiment. Ordinarily, as a PWM frequency is higher and as the duty ratio is larger, the generated heat of the FETQ due to a switching loss is more increased. Thus, as the PWM frequency of the pulse signal outputted from the load control part 33A-1 is higher, and as the duty ratio is larger, the threshold value determining part 33A-3 further changes the threshold value so that the threshold value is lower. Thus, the FETQ can be interrupted by further considering the generated heat of the FETQ due to the switching loss and the breakage of the FETQ due to a thermal stress can be prevented.

According to the above-described third embodiment, the threshold value is changed in accordance with both the PWM frequency and the duty ratio, however, the present invention is not limited thereto. For instance, the threshold value may be changed in accordance with either the PWM frequency or the duty ratio.

Further, according to the above-described first to third embodiments, the FETQ is used as the semiconductor switch, however, the present invention is not limited thereto. For instance, as the semiconductor switch, a switching transistor may be used.

Further, the above-described embodiments merely show representative forms of the present invention, and the present invention is not limited to these embodiments. That is, various modifications may be made and embodied within a scope without departing the gist of the present invention.
The present application is based on Japan Patent Application No. 2007-222160 filed on August 29, 2007, the contents of which are incorporated herein for reference.

## Claims

1. A protecting circuit, comprising:
a semiconductor switch that is provided between a power source and a load;
a current detecting unit that detects an electric current flowing in the semiconductor switch;
a protecting unit that controls the semiconductor switch to be turned off when the current detected by the current detecting unit exceeds a threshold value;
a temperature detecting unit that detects an ambient temperature; and
a threshold value changing unit that changes the threshold value so as to lower the threshold value as the temperature detected by the temperature detecting unit becomes higher.

2. The protecting circuit according to claim 1, wherein the temperature detecting unit includes a diode for protecting a reverse connection of the power source, and the diode being provided between the power source and the load.

3. The protecting circuit according to claim 2, wherein the temperature detecting unit detects the temperature on the basis of an end-to-end voltage of the diode for protecting the reverse connection and the current detected by the current detecting unit.

4. The protecting circuit according to claim 1, further comprising:
a driving unit that supplies a pulse signal to the semiconductor switch to pulse drive the semiconductor switch,
wherein as at least one of a frequency of the pulse signal is higher and a duty ratio is larger, the threshold value changing unit changes the threshold value so as to be lower.
